(19) Europäisches Patentamt
European Patent Office
Office européen des brevets

(11) **EP 1 575 032 B1**

(12) **EUROPEAN PATENT SPECIFICATION**

(45) Date of publication and mention
of the grant of the patent:
**03.03.2010 Bulletin 2010/09**

(51) Int Cl.:
***G10L 19/00*** (2006.01)

(21) Application number: **05251452.8**

(22) Date of filing: **10.03.2005**

(54) **Lossless audio coding/decoding method and apparatus**

Verfahren und Vorrichtung zur verlustfreien Audiokodierung und -dekodierung

Procédé et dispositif pour le codage et décodage audio sans perte

(84) Designated Contracting States:
**DE ES FI FR GB NL**

(30) Priority: **10.03.2004 US 551359 P**
**30.06.2004 KR 2004050479**

(43) Date of publication of application:
**14.09.2005 Bulletin 2005/37**

(73) Proprietor: **SAMSUNG ELECTRONICS CO., LTD.**
**Suwon-si,**
**Gyeonggi-do (KR)**

(72) Inventors:
• **Ennmi, Oh**
**Bundang-gu, Seongnam-si, Gyeonggi-do (KR)**
• **Kim, Junghoe**
**Seoul (KR)**
• **Lei, Miao c/o 2F Science and Technology Tower**
**Beijing 100081 (CN)**
• **Lee, Shihwa c/o 6-613, Seocho Hanyang Apt.**
**Seoul (KR)**
• **Kim, Sangwook c/o 1006-905 Kachi Maeul Apt.**
**Seoul (KR)**

(74) Representative: **Greene, Simon Kenneth**
**Elkington and Fife LLP**
**Prospect House**
**8 Pembroke Road**
**Sevenoaks**
**Kent TN13 1XR (GB)**

(56) References cited:
WO-A-03/027940            WO-A-03/077565
US-A1- 2003 187 634

• EUNMI OH, JUNG-HOE KIM, MIAO LEI, AND
SANGWOOK KIM: "Improvement of coding
efficiency in MPEG-4 audio scalable lossless
coding (SLS)" ISO/IEC JTC1/SC29/WG11,
MPEG2003/M10414, December 2003 (2003-12),
XP002392326
• YU R., LIN X., RAHARDJA S., KO C.C.: "A fine
granular scalable perceptually lossy and lossless
audio codec" 2003 IEEE INTERNATIONAL
CONFERENCE ON MULTIMEDIA AND EXPO 6-9
JULY 2003 BALTIMORE, MD, USA, vol. 1, 6 July
2003 (2003-07-06), pages I-65, XP002393418
Proceedings 2003 International Conference on
Multimedia and Expo (Cat. No.03TH8698) IEEE
Piscataway, NJ, USA ISBN: 0-7803-7965-9

**Description**

The present invention relates to coding and/or decoding of an audio signal, and more particularly, to a lossless audio coding/decoding method and apparatus capable of providing a greater compression ratio than in a bit-plane Golomb code (BPGC) using a text-based coding method.

Lossless audio coding methods include Meridian lossless audio compression coding, Monkey's audio coding, and free lossless audio coding. Meridian lossless packing (MLP) is applied and used in a digital versatile disk-audio (DVD-A).

As the bandwidth of Internet network increases, a large volume of multimedia contents can be provided. In the case of audio contents, a lossless audio method is needed. In the European Union (EU), digital audio broadcasting has already begun through digital audio broadcasting (DAB), and broadcasting stations and contents providers for this are using lossless audio coding methods. In response to this, MPEG group is also proceeding with standardization for lossless audio compression under the name of ISO/IEC 14496-3:2001 / AMD 5, Audio Scalable to Lossless Coding (SLS). This provides fine grain scalability (FGS) and enables lossless audio compression.

A compression ratio, which is the most important factor in a lossless audio compression technology, can be improved by removing redundant information between data items. The redundant information can be removed by prediction between neighboring data items and can also be removed by a context between neighboring data items.

Integer modified discrete cosine transform (MDCT) coefficients show a Laplacian distribution, and in this distribution, a compression method named Golomb code shows an optimal result. In order to provide the FGS, bit-plane coding is needed and a combination of the Golomb code and bit-plane coding is referred to as bit plane Golomb coding (BPGC), which provides an optimal compression ratio and FGS. However, in some cases the assumption that the integer MDCT coefficients show a Laplacian distribution is not correct in an actual data distribution. Since the BPGC is an algorithm devised assuming that integer MDCT coefficients show a Laplacian distribution, if the integer MDCT coefficients do not show a Laplacian distribution, the BPGC cannot provide an optimal compression ratio. Accordingly, a lossless audio coding and decoding method capable of providing an optimal compression ratio regardless of the assumption that the integer MDCT coefficients show a Laplacian distribution is needed.

A method for improving coding efficiency is suggested in the document ISO/IEC JTC/SC29/WG11 titled "Improvement of coding efficiency in MPEG-4 audio scalable lossless coding", Eunmi Oh Et al, presented at MPEG 2003 in December 2003, Hawaii, USA, pages 1 to 11. In this method, contexts are used to improve coding efficiency.

WO03/077565 teaches a coefficient bit modeller indended for use in JPEG 2000. Bit planes are coded in order from most significant bit to least significant bit using three passes. Bits are labeled as significant or insignificant and this state is changed to significant during the first two passes when the most significant bit for that coefficient is encountered.

Audio codecs are presented in Yu et al, "A fine granular scalable perceptually lossy and lossless audio codec", presented at 2003 IEEE International conference on multimedia and expo, July 2003 Baltimore MD USA, and recorded in the corresponding conference proceedings at volume 1 pages 1-65to 1-68, published by the IEEE, ISBN 0-7893-7965-9. The codecs use bit plane Golomb coding.

The present invention provides a lossless audio coding/decoding method and apparatus capable of providing an improved compression ratio regardless of the assumption that integer MDCT coefficients show a Laplacian distribution.

According to an aspect of the present invention, there is provided a lossless audio coding method according to claim 1.

In the calculating of the context of the selected binary sample, the significances of already coded samples of bit-planes on each identical frequency line in a plurality of frequency lines existing in the vicinity of a frequency line to which the selected binary sample belongs are obtained, and by binarizing the significances, the context value of the binary sample is catenated.

In the calculating of the context of the selected binary sample, the significances of already coded samples of bit-planes on each identical frequency line in a plurality of frequency lines existing before a frequency line to which the selected binary sample belongs are obtained; a ratio on how many lines among the plurality of frequency lines have significance is expressed in an integer, by multiplying the ratio by a predetermined integer value; and then, the context value is calculated by using the integer.

According to still another aspect of the present invention, there is provided a lossless audio coding apparatus according to claim 7.

According to a further aspect of the present invention, there is provided a lossless audio decoding method according to claim 13.

The calculating of the context may include: calculating a first context by using the significances of already decoded samples of bit-plane on each identical frequency line in a plurality of frequency lines existing in the vicinity of a frequency line to which a sample to be decoded belongs; and calculating a second context by using the significances of already decoded samples of bit-planes on each identical frequency line in a plurality of frequency lines before a frequency line to which a sample to be decoded belongs.

According to an additional aspect of the present invention, there is provided a lossless audio decoding apparatus according to claim 15.

The lossless decoding unit may include: a parameter obtaining unit obtaining a Golomb parameter from a bitstream of audio data; a parameter obtaining unit obtaining a Golomb parameter from a bitstream of audio data; a sample selection unit selecting a binary sample to be decoded in the order from a most significant bit to a least significant bit and from a lower frequency to a higher frequency; a context calculation unit calculating the context of the selected binary sample by using the significance of already coded bit-planes for each of a plurality of frequency lines existing in the vicinity of a frequency line to which the selected binary sample belongs; a probability model selection unit selecting a probability model by using the Golomb parameter and context; and an arithmetic decoding unit performing arithmetic-decoding by using the selected probability model.

The context calculation unit may include: a first context calculation unit obtaining the significances of already coded samples of bit-planes on each identical frequency line in a plurality of frequency lines existing in the vicinity of a frequency line to which the selected binary sample belongs, and by binarizing the significances, calculating a first context; and a second context calculation unit obtaining the significances of already coded samples of bit-planes on each identical frequency line in a plurality of frequency lines existing before a frequency line to which the selected binary sample belongs, expressing a ratio on how many lines among the plurality of frequency lines have significance, in an integer, by multiplying the ratio by a predetermined integer value, and then, calculating a second context by using the integer.

According to an additional aspect of the present invention, there is provided a computer readable recording medium having embodied thereon a computer program for the methods.

The above and other features and advantages of the present invention will become more apparent by describing in detail exemplary embodiments thereof with reference to the attached drawings in which:

FIG. 1 is a block diagram of the structure of a preferred embodiment of a lossless audio coding apparatus according to the present invention;
FIG. 2 is a block diagram of the structure of a lossless coding unit of FIG. 1;
FIG. 3 is a block diagram of the structure of another preferred embodiment of the lossless audio coding apparatus according to the present invention
FIG. 4 is a block diagram of the structure of a lossless coding unit of FIG. 3;
FIG. 5 is a flowchart of the operations performed by the lossless audio coding apparatus shown in FIG. 1;
FIG. 6 is a flowchart of the operations performed by the lossless coding unit shown in FIG. 1;
FIG. 7 is a flowchart of the operations performed by the lossless audio coding apparatus shown in FIG. 3;
FIG. 8 is a diagram showing a global context in a context calculation unit;
FIG. 9 is a graph showing a probability that 1 appears when a global context is calculated in a context calculation unit;
FIG. 10 is a diagram showing a local context in a context calculation unit;
FIG. 11 is a graph showing a probability that 1 appears when a local context is calculated in a context calculation unit;
FIG. 12 is a diagram showing a full context mode of a preferred embodiment according to the present invention;
FIG. 13 is a diagram showing a partial context mode of a preferred embodiment according to the present invention;
FIG. 14 is an example type of a pseudo code for context-based coding according to the present invention;
FIG. 15 is a block diagram of the structure of a preferred embodiment of a lossless audio decoding apparatus according to the present invention;
FIG. 16 is a block diagram of the structure of a context calculation unit shown in FIG. 15;
FIG. 17 is a block diagram of the structure of another preferred embodiment of the lossless audio decoding apparatus according to the present invention;
FIG. 18 is a block diagram of the structure of a lossless decoding unit of FIG. 17;
FIG. 19 is a flowchart of the operations performed by the lossless audio decoding apparatus shown in FIG. 15; and
FIG. 20 is a flowchart of the operations performed by the lossless audio decoding apparatus shown in FIG. 17.

A lossless audio coding/decoding method and apparatus according to the present invention will now be described more fully with reference to the accompanying drawings, in which exemplary embodiments of the invention are shown.

In audio coding, in order to provide fine grain scalability (FGS) and lossless coding, integer modified discrete cosine transform (MDCT) is used. In particular, it is known that if the input sample distribution of the audio signal follows Laplacian distribution, a bit plane Golomb coding (BPGC) method shows an optimal compression result, and this provides a result equivalent to a Golomb code. A Golomb parameter can be obtained by the following procedure:

$$\text{For}(L=0;(N<<L+1))<=A;L++);$$

According to the procedure, Golomb parameter L can be obtained and due to the characteristic of the Golomb code, a probability that 0 or 1 appears in a bit-plane less than L is equal to 1/2. In the case of Laplacian distribution this result is optimal but if the distribution is not a Laplacian distribution, an optimal compression ratio cannot be provided. Accordingly, the basic idea of the present invention is to provide an optimal compression ratio by using a context through a statistical analysis via a data distribution does not follow the Laplacian distribution.

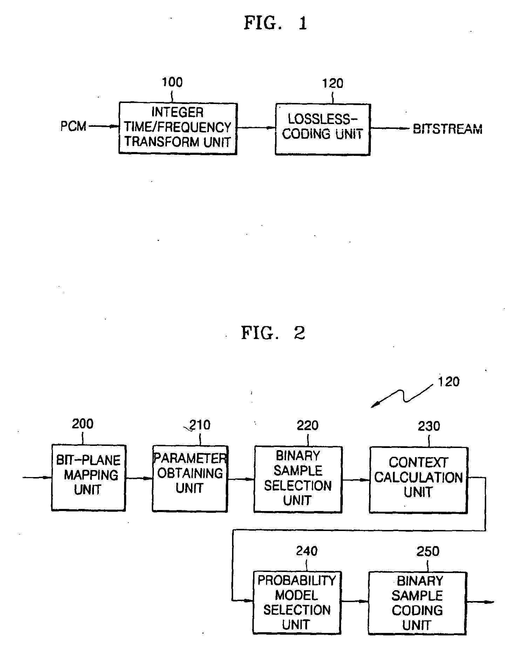

FIG. 1 is a block diagram of the structure of a preferred embodiment of a lossless audio coding apparatus according to the present invention. The lossless audio coding apparatus includes an integer time/frequency transform unit 100 and a lossless coding unit 120. The integer time/frequency transform unit 100 transforms an audio signal in the time domain into an audio spectral signal in the frequency domain having an integer value, and preferably, uses integer MDCT. The lossless coding unit 120 maps the audio signal in the frequency domain into bit-plane data with respect to the frequency, and lossless-codes binary samples forming the bit-plane using a predetermined context. The lossless coding unit 120 is formed with a bit-plane mapping unit 200, a parameter obtaining unit 210, a binary sample selection unit 220, a context calculation unit 230, a probability model selection unit 240, and a binary sample coding unit 250.

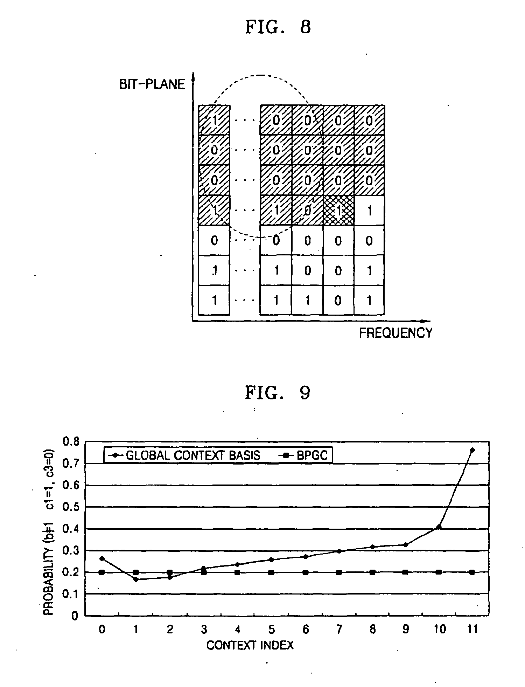

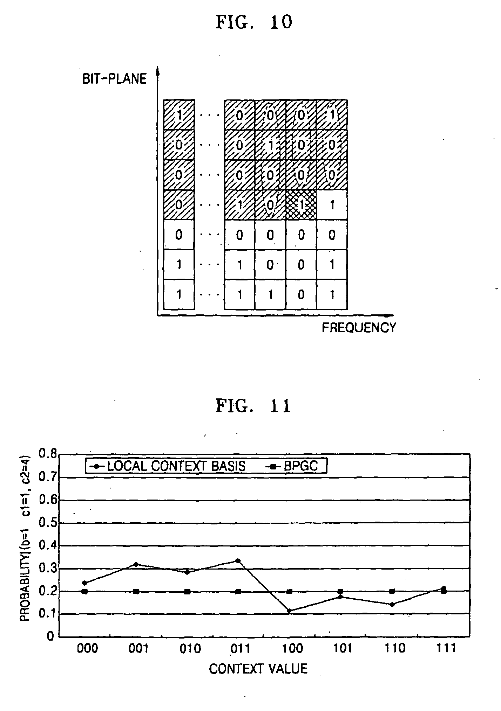

The bit-plane mapping unit 200 maps the audio signal in the frequency domain into bit-plane data with respect to the frequency. FIGS. 8 and 10 illustrate examples of audio signals mapped into bit-plane data with respect to the frequency.

The parameter obtaining unit 210 obtains the most significant bit (MSB) of the bit-plane and a Golomb parameter. The binary sample selection unit 220 selects a binary sample on a bit-plane to be coded in the order from a MSB to a least significant bit (LSB) and from a lower frequency component to a higher frequency component.

The context calculation unit 230 calculates the context of the selected binary sample by using the significances of already coded bit-planes for each of a plurality of frequency lines existing in the vicinity of a frequency line to which the selected binary sample belongs. The probability model selection unit 240 selects a probability model by using the obtained Golomb parameter and the calculated contexts. The binary sample coding unit 250 lossless-codes the binary sample by using the selected probability model.

In FIG.2 all binary samples are coded using context-based lossless coding. However, in another embodiment, for complexity some binary samples on the bit-plane are coded using context-based lossless coding and other binary samples on the bit-plane are coded using bit-packing. Golomb parameter is used for determining binary samples on bit-plane to be coded using bit-packing since a probability of being '1' of the binary sample under the Golomb parameter is 1/2.

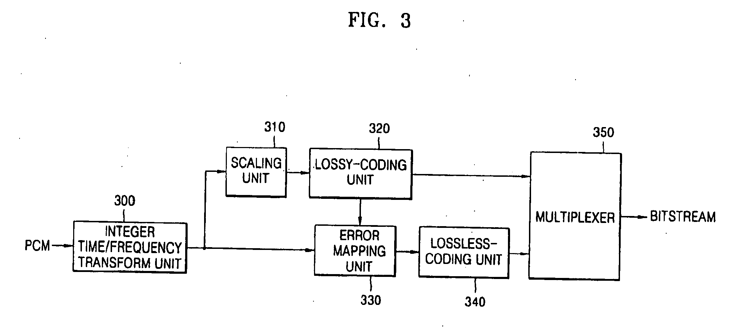

FIG. 3 is a block diagram of the structure of another preferred embodiment of the lossless audio coding apparatus according to the present invention. The apparatus is formed with an integer time/frequency transform unit 300, a scaling unit 310, a lossy coding unit 320, an error mapping unit 330, a lossless coding unit 340, and a multiplexer 350.

The integer time/frequency transform unit 300 an audio signal in the time domain into an audio spectral signal in the frequency domain having an integer value, and preferably uses integer MDCT. The scaling unit 310 scales the audio frequency signal of the integer time/frequency transform unit 300 to be used as an input signal of the lossy coding unit 320. Since the output signal of the integer time/frequency transform unit 300 is represented as an integer, it cannot be directly used as an input of the lossy coding unit 320. Accordingly, the audio frequency signal of the integer time/frequency transform unit 300 is scaled in the scaling unit so that it can be used as an input signal of the lossy coding unit 320.

The lossy coding unit 320 lossy-codes the scaled frequency signal and preferably, uses an AAC core coder. The error mapping unit 330 obtains an error mapped signal corresponding to the difference of the lossy-coded signal and the signal of the integer time/frequency transform unit 300. The lossless coding unit 340 lossless-codes the error mapped signal by using a context. The multiplexer 350 multiplexes the lossless-coded signal of the lossless coding unit 340 and the lossy-coded signal of the lossy coding unit 320, and generates a bitstream.

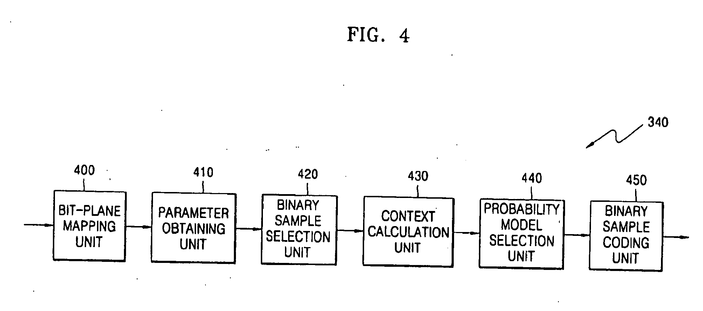

FIG. 4 is a block diagram of the structure of the lossless coding unit 340, which is formed with a bit-plane mapping unit 400, a parameter obtaining unit 410, a binary sample selection unit 420, a context calculation unit 430, a probability model selection unit 440, and a binary sample coding unit 450.

The bit-plane mapping unit 400 maps the error mapped signal of the error mapping unit 330 into bit-plane data with respect to the frequency. The parameter obtaining unit 410 obtains the MSB of the bit-plane and a Golomb parameter. The binary sample selection unit 420 selects a binary sample on a bit-plane to be coded in the order from a MSB to a LSB, and from a lower frequency component to a higher frequency component. The context caicuiation unit 430 calculates the context of the selected binary sample, by using the significances of already coded bit-planes for each of a plurality of frequency lines existing in the vicinity of a frequency line to which the selected binary sample belongs. The probability model selection unit 440 selects a probability model by using the obtained Golomb parameter and the calculated contexts. The binary sample coding unit 450 lossless-codes the binary sample by using the selected probability model.

In FIG.4 all binary samples are coded using context-based lossless coding. However, in another embodiment, for complexity reduction some binary samples on the bit-plane are coded using context-based lossless coding and other binary samples on the bit-plane are coded using bit-packing. Golomb parameter is used for determining binary samples on bit-plane to be coded using bit-packing since a probability of being '1' of the binary sample under the Golomb parameter is 1/2.

Calculation of a context value of the binary sample in the context calculation units 230 and 430 shown in FIGS. 2 and 4 will now be explained. The significance that is used in related to the embodiment of the present invention is defined as 1 if one spectral component is coded as 1 at least once among previous samples coded on bit-planes on an identical frequency line to a current time, and defined as 0 if no spectral component is coded as 1.

Also, the context calculation units 230 and 430 can calculate the context of the binary sample using, for example, global context calculation. The global context calculation considers the distribution of the entire spectrum, and uses the fact that the shape of the envelope of the spectrum does not change rapidly on the frequency axis, and comes to have a look similar to the shape of the previous envelope. In the global context calculation, taking the frequency line of the selected binary sample as a basis, the context calculation units 230 and 430 obtain a probability value that the significance is '1' by using already coded predetermined samples among bit-planes on each frequency line existing before the frequency line of the selected binary sample. Then, the context calculation units 230 and 420 multiply the probability value by a predetermined integer value to express it in an integer, and by using the integer, calculate the context value of the binary sample.

Also, the context calculation units 230 and 430 can calculate the context of the binary sample using local context calculation. The local context calculation uses correlation of adjacent binary samples, and the significance as the global context calculation. The significance of a sample on each of predetermined N bitstreams on an identical frequency of a binary sample to be currently coded is binarized and then, converted again into a decimal number, and then, the context is calculated. In the local context calculation, taking the frequency line of the selected binary sample as the basis, the context calculation unit 230 and 430 obtain respective significances by using predetermined samples among bit-planes on each of frequency lines existing in a predetermined range before and after the frequency line of the selected binary sample, and by converting the significances into scalar values, calculate the context value of the binary sample. Value N used in this calculation is less than value M used in the global context calculation.

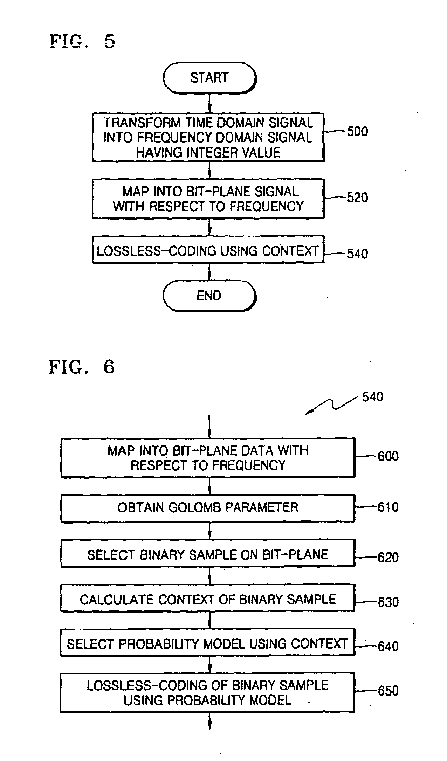

FIG. 5 is a flowchart of the operations performed by the lossless audio coding apparatus shown in FIG. 1. First, a PCM signal corresponding to an audio signal in the time domain is input to the integer time/frequency transform unit 100, this is transformed to an audio spectral signal in the frequency domain having an integer value in operation 500. Here, preferably, int MDCT is used. Then, as in FIGS. 8 and 10, the audio signal in the frequency domain is mapped into a bit-plane signal with respect to the frequency in operation 520. Then, a binary sample forming the bit-plane is lossless-coded using a probability model determined by using a predetermined context in operation 540.

FIG. 6 is a flowchart of the operations performed by the lossless coding unit 120 shown in FIG. 1.

First, if the audio signal in the frequency domain is input to the bit-plane mapping unit 200, the audio signal in the frequency domain is mapped into bit-plane data with respect to the frequency in operation 600. Also, through the Golomb parameter obtaining unit 210, the MSB and a Golomb parameter are obtained in each bit-plane in operation 610. Then, through the binary sample selection unit 220, a binary sample on a bit-plane to be coded in the order from a MSB to a LSB and from a lower frequency component to a higher frequency component is selected in operation 620. With regard to the selected binary sample, the context of the binary sample selected in the binary sample selection unit 220 is calculated by using the significances of already coded bit-planes for each of a plurality of frequency lines existing in the vicinity of a frequency line to which the selected binary sample belongs, in operation 630. A probability model is selected by using the Golomb parameter obtained in the Golomb parameter obtaining unit 210 and the contexts calculated in the context calculation unit 230 in operation 640. By using the probability model selected in the probability model selection unit 240, the binary sample is lossless-coded in operation 650.

In FIG.6 all binary samples are coded using context-based lossless coding. However, in another embodiment, for complexity reduction some binary samples on the bit-plane are coded using context-based lossless coding and other binary samples on the bit-plane are coded using bit-packing. Golomb parameter is used for determining binary samples on bit-plane to be coded using bit-packing since a probability of being '1' of the binary sample under the Golomb parameter is 1/2.

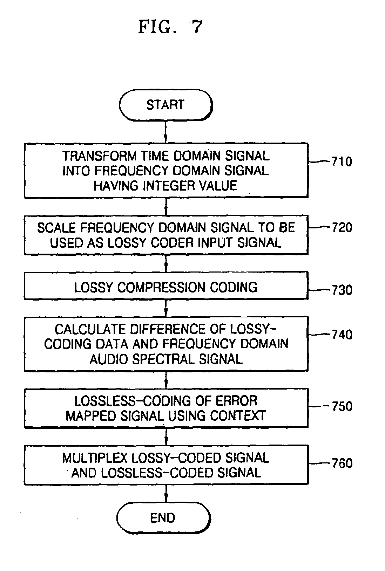

FIG. 7 is a flowchart of the operations performed by the lossless audio coding apparatus shown in FIG. 3, and referring to FIG. 7, the operation of the another preferred embodiment of the lossless audio coding apparatus will now be explained. First, through the integer time/frequency transform unit 300, an audio signal in the time domain is transformed into an audio spectral signal in the frequency domain having an integer value in operation 710.

Then, the audio spectral signal in the frequency domain is scaled in the scaling unit 310 to be used as an input signal of the lossy coding unit 320 in operation 720. The frequency signal scaled in the scaling unit 310 is lossy compression coded in the lossy compression coding unit 320 in operation 730. Preferably, the lossy compression coding is performed by an AAC Core coder.

An error mapped signal corresponding to the difference of the data lossy-coded in the lossy coding unit 320 and the audio spectral signal in the frequency domain having an integer value is obtained in the error mapping unit 330 in operation 740. The error mapped signal is lossless-coded by using a context in the lossless coding unit 340 in operation 750.

The signal lossless-coded in the lossless coding unit 340 and the signal lossy-coded in the lossy coding unit 320 are multiplexed in the multiplexer 350 and are generated as a bitstream in operation 760. In the lossless coding in operation 750, the error mapped signal is mapped into bit-plane data with respect to the frequency. Then, the process of obtaining the MSB and Golomb parameter is the same as described with reference to FIG. 6 and will be omitted here.

Generally, due to spectral leakage by MDCT, there is correlation of neighboring samples on the frequency axis. That is, if the value of an adjacent sample is X, it is highly probable that the value of a current sample is a value in the vicinity of X. Accordingly, if an adjacent sample in the vicinity of X is selected as a context, the compression ratio can be improved by using the correlation.

Also, it can be known through statistical analyses that the value of a bit-plane has a higher correlation with the probability distribution of a lower order sample. Accordingly, if an adjacent sample in the vicinity of X is selected as a context, the compression ratio can be improved by using the correlation.

A method of calculating a context will now be explained.

FIG. 8 is a diagram to obtain a context by using a global context in a context calculation unit. By using the part indicated by dotted lines, the probability distribution of a current sample is obtained from already coded samples. FIG. 9 is a graph showing a probability that 1 appears when a context is calculated in a context calculation unit using a global context.

Referring to FIG. 8, it is assumed that a symbol in the box indicated by grid lines is going to be coded. In FIG. 8, the global context is expressed as the part in the dotted oval. Referring to FIG. 9, the other two types of contexts are fixed as Golomb context (Context 1) = 1, and local context (Context 2) = 0. The graph shows that in the context calculation using the BPGC, the probability that 1 appears is maintained at a constant level, while the context calculation using the global context, the probability that 1 appears increases gradually as the context index becomes higher.

FIG. 10 is a diagram to obtain a context by using a local context in a context calculation unit. FIG. 11 is a graph showing a probability that 1 appears when a context is calculated in a context calculation unit using a local context.

Referring to FIG. 10, in the local context calculation, significances are obtained on three neighboring frequency lines. Bit pattern is mapped to a value in a range from 0 to 7 (that is, 000, 001, 010, 011, 100, 110, 111 in binary numbers) to compute symbol probability. In the local context calculation, by using the three parts indicated by dotted lines, as shown in FIG. 10, the probability distribution of a current sample is calculated from already coded samples. Here, the probability that 1 appears in the current coding is in the range from 0 to 7 as shown above, and is determined by the three values such as bit pattern [0,1,1]. FIG. 11 shows the probability that 1 appear when a context is calculated using a local context when the other two contexts are fixed as Golomb context (Context 1) = 1 and global context (Context 2) = 4. Here, the graph shows that when the BPGC is used, the probability that 1 appears is fixed at a constant level. Meanwhile, when the context is calculated by a global context, the probability that 1 appears is higher in the first half than that of the BPGC, but is lower in the second half than that of the BPGC.

In an actual example of coding, if among 10 neighboring samples to be coded in order to calculate a global context, five samples have significance 1, the probability is 0.5 and if this is scaled with a value of 8, it becomes a value of 4. Accordingly, the global context is 4. Meanwhile, when significances of 2 samples before and after are checked in order to calculate a local context, if (i-2)-th sample is 1, (i-1)-th sample is 0, (i+1)-th sample is 0, and (i+2)-th sample is 1, the result of binarization is 1001, and equal to 9 in the decimal expression. If the Golomb parameter of data to be currently coded is 4, Golomb parameter (Context 1) =4, global context (Context 2) =4, and local context (Context 3) = 9. By using the Golomb parameter, global context, and local context, a probability model is selected.

The probability models varies with respect to the implementation, and among them, using a three-dimensional array, one implementation method can be expressed as:

$$\text{Prob[Golomb][Context1][Context2]}$$

Using thus obtained probability model, lossless-coding is performed. As a representative lossless coding method, an arithmetic coding method can be used.

By the present invention, overall compression is improved by 0.8% when it's compared with prior method not using the context.

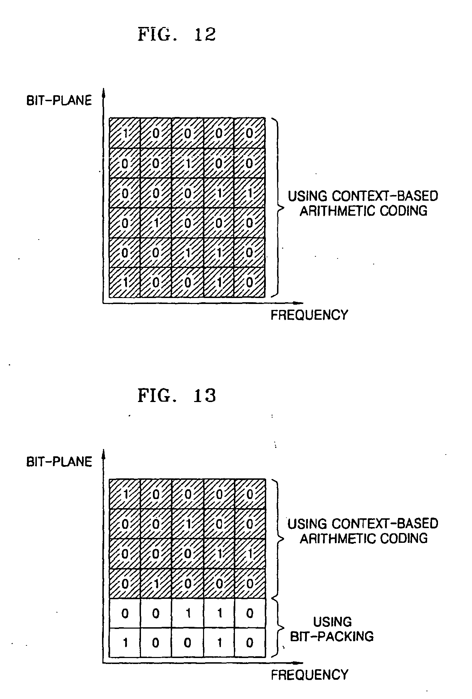

FIG. 12 is a diagram showing a full context mode of a preferred embodiment according to the present invention. FIG. 13 is a diagram showing a partial context mode of a preferred embodiment according to the present invention.

Referring to FIG. 12 , all binary samples are coded using context-based arithmetic coding. However, Referring FIG. 13, in another embodiment, for complexity some binary samples on the bit-plane are coded using context-based arithmetic coding and other binary samples on the bit-plane are coded using bit-packing i.e. a probability 1/2 is assigned for that binary samples.

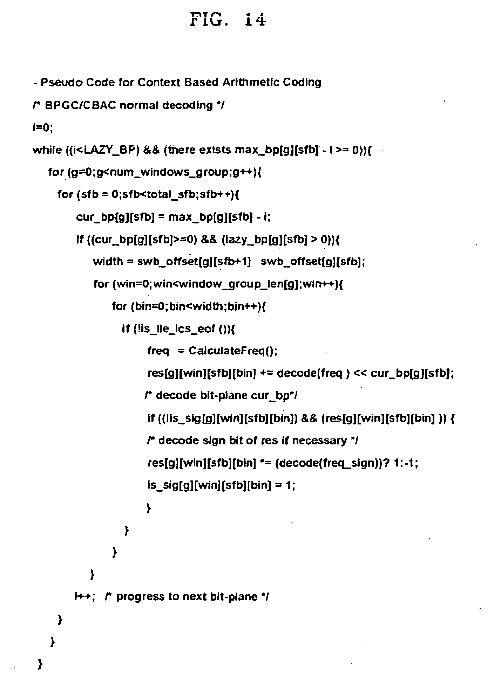

FIG. 14 shows a pseudo code for context-based coding in relation to an embodiment of the present invention.

A lossless audio decoding apparatus and method according to the present invention will now be explained.

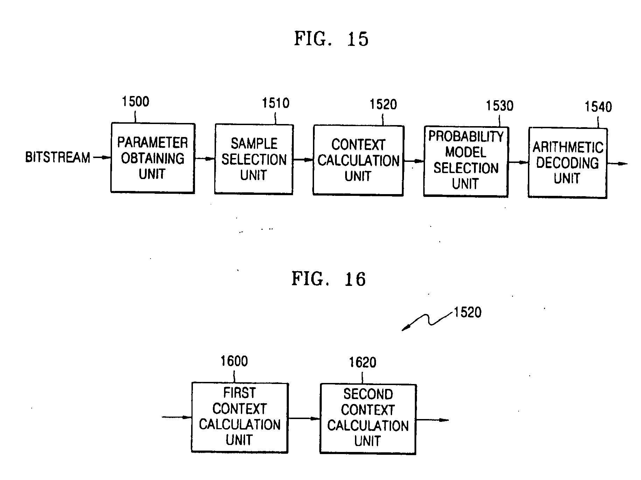

FIG. 15 is a block diagram of the structure of a preferred embodiment of a lossless audio decoding apparatus according to the present invention. The apparatus includes a parameter obtaining unit 1500, a sample selection unit 1510, a context calculation unit 1520, a probability model selection unit 1530, and an arithmetic decoding unit 1540.

When a bitstream of audio data is input, the parameter obtaining unit 1500 obtains the MSB and Golomb parameter from the bitstream. The sample selection unit 1510 selects a binary sample to be decoded in the order from a MSB to a LSB and from a lower frequency to a higher frequency.

The context calculation unit 1520 calculates a predetermined context by using already decoded samples, and as shown in FIG. 16, is formed with a first context calculation unit 1600 and a second context calculation unit 1620. The first context calculation unit 1600 obtains significances of already coded samples of bit-planes on each identical frequency line in a plurality of frequency lines existing before the frequency line to which the selected binary sample belongs, binarizes the significances, and calculates a first context. The second context calculation unit 1620 obtains significances of already coded samples of bit-planes on each identical frequency line in a plurality of frequency lines existing in the vicinity of the frequency line to which the selected binary sample belongs; expresses a ratio on how many lines among the plurality of frequency lines have significance, in an integer, by multiplying the ratio by a predetermined integer value; and then, calculates a second context by using the integer.

The probability model selection unit 1530 selects a probability model by using the Golomb parameter of the parameter obtaining unit 1500 and the context calculated in the context calculation unit 1520. The arithmetic decoding unit 1540 performs arithmetic-decoding by using the probability model selected in the probability model selection unit 1530.

In FIG.15 all binary samples are decoded using context-based lossless decoding. However, in another embodiment, for complexity reduction some binary samples on the bit-plane are decoded using context-based lossless decoding and other binary samples on the bit-plane are decoded using bit-packing. Golomb parameter is used for determining binary samples on bit-plane to be decoded using bit-packing since a probability of being '1' of the binary sample under the Golomb parameter is 1/2.

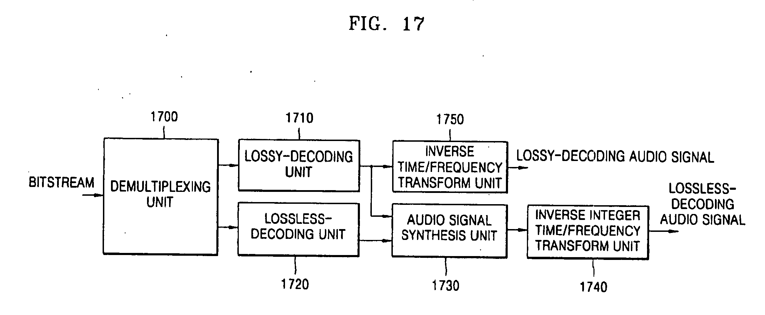

FIG. 17 is a block diagram of the structure of another preferred embodiment of the lossless audio decoding apparatus according to the present invention. The apparatus includes a demultiplexing unit 1700, a lossy decoding unit 1710, a lossless decoding unit 1720, an audio signal synthesis unit 1730, and an inverse integer time/frequency transform unit 1740 and preferably, further includes an inverse time/frequency transform unit 1750.

When an audio bitstream is input, the demultiplexing unit 1700 demultiplexes the audio bitstream and extracts a lossy bitstream formed by a predetermined lossy coding method used when the bitstream is coded, and an error bitstream of the error data.

The lossy decoding unit 1710 lossy-decodes the lossy bitstream extracted in the demultiplexing unit 1700, by a predetermined lossy decoding method corresponding to a predetermined lossy coding method used when the bitstream is coded. The lossless decoding unit 1720 lossless-decodes the error bitstream extracted in the demultiplexing unit 1700, also by a lossless decoding method corresponding to lossless coding.

The audio signal synthesis unit 1730 synthesizes the decoded lossy bitstream and error bitstream and restores a frequency spectral signal. The inverse integer time/frequency transform unit 1740 inverse integer time/frequency transforms the frequency spectral signal restored in the audio signal synthesis unit 1730, and restores an audio signal in the time domain.

Then, the inverse time/frequency transform unit 1750 restores the audio signal in the frequency domain decoded in the lossy decoding unit 1710, into an audio signal in the time domain, and the thus restored signal is the lossy decoded signal.

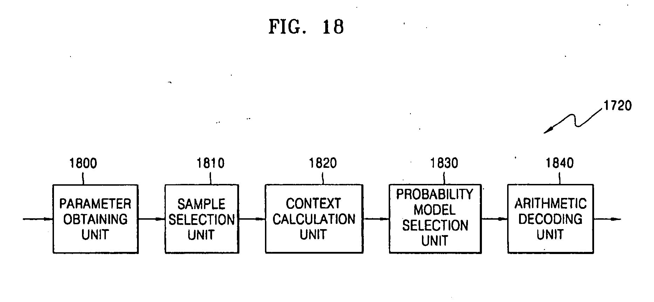

FIG. 18 is a block diagram of the structure of the lossless decoding unit 1720 of FIG. 17, which includes a parameter obtaining unit 1800, a sample selection unit 1810, a context calculation unit 1820, a probability model selection unit 1830, and an arithmetic decoding unit 1840.

The parameter obtaining unit 1800 obtains the MSB and Golomb parameter from a bitstream of audio data. The sample selection unit 1810 selects a binary sample to be decoded in the order from a MSB to a LSB and from a lower frequency to a higher frequency.

The context calculation unit 1820 calculates a predetermined context by using already decoded samples, and is formed with a first context calculation unit and a second context calculation unit. The first context calculation unit 1600 obtains significances of already coded samples of bit-planes on each identical frequency line in a plurality of frequency lines existing before the frequency line to which the selected binary sample belongs, binarizes the significances, and calculates a first context. The second context calculation unit 1620 obtains significances of already coded samples of bit-planes on each identical frequency line in a plurality of frequency lines existing in the vicinity of the frequency line to which the selected binary sample belongs; expresses a ratio on how many lines among the plurality of frequency lines have significance, in an integer, by multiplying the ratio by a predetermined integer value; and then, caicuiates a second context by using the integer.

The probability model selection unit 1830 selects a probability model by using the Golomb parameter and the context. The arithmetic decoding unit 1840 performs arithmetic-decoding using the selected probability model.

In FIG.18 all binary samples are decoded using context-based lossless decoding. However, in another embodiment, for complexity reduction some binary samples on the bit-plane are decoded using context-based lossless decoding and other binary samples on the bit-plane are decoded using bit-packing. Golomb parameter is used for determining binary samples on bit-plane to be decoded using bit-packing since a probability of being '1' of the binary sample under the Golomb parameter is 1/2.

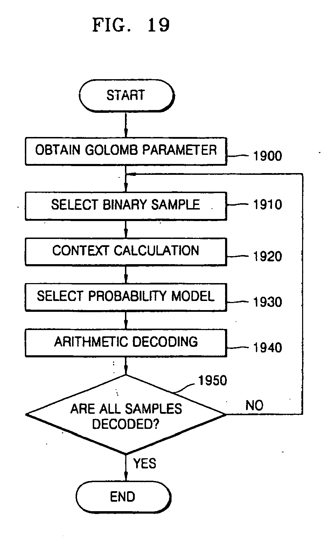

FIG. 19 is a flowchart of the operations performed by the lossless audio decoding apparatus shown in FIG. 15.

First, a bitstream of audio data is input to the parameter obtaining unit 1500, a Golomb parameter is obtained from the bitstream of audio data in operation 1900.

Then, a binary sample to be decoded in the order from a MSB to a LSB and from a lower frequency to a higher frequency is selected in the sample selection unit 1510 in operation 1910.

If a sample to be decoded is selected in the sample selection unit 1510, a predetermined context is calculated by using already decoded samples in the context calculation unit 1520 in operation 1920. Here, the context is formed with a first context and a second context, and as shown in FIG. 16, the first context calculation unit 1600 obtains significances of already coded samples of bit-planes on each identical frequency line in a plurality of frequency lines existing before the frequency line to which the selected binary sample belongs, binarizes the significances, and calculates a first context. Then, the second context calculation unit 1620 obtains significances of already coded samples of bit-planes on each identical frequency line in a plurality of frequency lines existing in the vicinity of the frequency line to which the selected binary sample belongs; expresses a ratio on how many lines among the plurality of frequency lines have significance, in an integer, by multiplying the ratio by a predetermined integer value; and then, calculates a second context by using the integer.

Then, through the probability model selection unit 1530, a probability model is selected by using the Golomb parameter and the first and second contexts in operation 1930. If the probability model is selected in the probability model selection unit 1530, arithmetic decoding is performed by using the selected probability model in operation 1940. The operations 1910 through 1940 are repeatedly performed until all samples are decoded in operation 1950.

In FIG.19 all binary samples are decoded using context-based lossless decoding. However, in another embodiment, for complexity reduction some binary samples on the bit-plane are decoded using context-based lossless decoding and other binary samples on the bit-plane are decoded using bit-packing. Golomb parameter is used for determining binary samples on bit-plane to be decoded using bit-packing since a probability of being '1' of the binary sample under the Golomb parameter is 1/2.

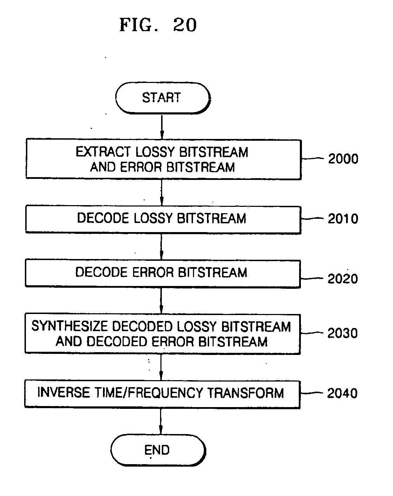

FIG. 20 is a flowchart of the operations performed by the lossless audio decoding apparatus shown in FIG. 17.

The difference of lossy-coded audio data and an audio spectral signal in the frequency domain having an integer value will be defined as error data. First, if an audio bitstream is input to the demultiplexing unit 1700, the bitstream is demultiplexed and a lossy bitstream generated through predetermined lossy coding and the error bitstream of the error data are extracted in operation 2000.

The extracted lossy bitstream is input to the lossy decoding unit 1710, and lossy-decoded by a predetermined lossy decoding method corresponding to the lossy coding when the data is coded in operation 2010. Also, the extracted error bitstream is input to the lossless decoding unit 1720 and lossless-decoded in operation 2020. The more detailed process of the lossless decoding in operation 2020 is the same as shown in FIG. 19.

The lossy bitstream lossy-decoded in the lossy decoding unit 1710 and the error bitstream lossless-decoded in the lossless decoding unit 1720 are input to the audio signal synthesis unit 1730 and are restored into a frequency spectral signal in operation 2030. The frequency spectral signal is input to the inverse integer time/frequency transform unit 1740 and is restored to an audio signal in the time domain in operation 2040.

The present invention can also be embodied as computer readable codes on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, and optical data storage devices.

While the present invention has been particularly shown and described with reference to exemplary embodiments thereof, it will be understood by those of ordinary skill in the art that various changes in form and details may be made therein without departing from the scope of the present invention as defined by the following claims. The preferred embodiments should be considered in descriptive sense only and not for purposes of limitation. Therefore, the scope of the invention is defined not by the detailed description of the invention but by the appended claims, and all differences within the scope will be construed as being included in the present invention.

In the lossless audio coding/decoding method and apparatus according to the present invention, an optimal performance is provided through a model based on statistical distributions using a global context and a local context regardless of the distribution of an input when lossless audio coding and/or decoding is performed. Also, regardless of the assumption that integer MDCT coefficients show a Laplacian distribution, an optimal compression ratio is provided and through a context-based coding method, a compression ratio better than that of the BPGC is provided.

## Claims

1. A lossless audio coding method comprising:

   mapping (600) an audio spectral signal in the frequency domain having integer values into a bit-plane signal with respect to the frequency;
   obtaining (610) a most significant bit and a Golomb parameter for each bit-plane;
   selecting (620) a binary sample of a bit-plane to be coded in the order from the most significant bit to the least significant bit and from a lower frequency component to a higher frequency component;
   calculating (630) the context of the selected binary sample;
   selecting (640) a probability model of the binary sample by using the obtained Golomb parameter and the calculated contexts; and
   arithmetic lossless-coding (650) the binary sample by using the selected probability model;
   **characterized in that** the context of the selected binary sample is calculated using the significances of already coded binary samples for each of a plurality of frequency lines existing in the vicinity of a frequency line to which the selected binary sample belongs;
   wherein the significance of a binary sample is '1' if there is at least one '1' in already coded bit-planes in the frequency line of the binary sample and if there is no '1' in the frequency line of the binary sample, the significance of the binary sample is '0'.

2. The method of claim 1, wherein in the step of calculating (630) of the context of the selected binary sample, the significances of already coded binary samples of bit-planes on each frequency line in a plurality of frequency lines existing in the vicinity of a frequency line to which the selected binary sample belongs are obtained, and by binarizing the significance, the context value of the binary sample is calculated.

3. The method of any preceding claim, wherein in the calculating (630) of the context of the selected binary sample, the significances of already coded binary samples of bit-planes on each frequency line in a plurality of frequency lines existing before a frequency line to which the selected binary sample belongs are obtained; a ratio on how many binary samples among the plurality of binary samples have significance "1" is expressed in an integer, by multiplying the ratio by a predetermined integer value; and then, the context value of the binary sample is calculated by using the integer.

4. The method of any preceding claim, wherein the calculating of the context of the selected binary sample comprises
   calculating a first context by using the significances of already coded binary samples of bit-plane on each frequency line in a first plurality of frequency lines existing in the vicinity of a frequency line to which a binary sample to be coded belongs; and
   calculating a second context by using the significances of already coded binary samples of bit-planes on each frequency line in a second plurality of frequency lines before a frequency line to which a binary sample to be coded belong.

5. The method of any preceding claim, wherein some binary samples on the bit-plane are coded with probability of 0.5.

6. A lossless audio coding method according to any of claims 1 to 5 comprising:

   scaling (720) an audio spectral signal in the frequency domain having integer values to be used as an input signal of a lossy coder;
   lossy compression coding (730) the scaled frequency signal;
   obtaining (740) an error mapped signal corresponding to the difference of the lossy coded data and the audio spectral signal in the frequency domain having an integer value;
   lossless-coding (750) the error mapped signal using a method according to any of claims 1 to 6 using the error mapped signal as the audio spectral signal; and
   generating a bitstream by multiplexing (760) the lossless coded signal and the lossy coded signal.

7. A lossless audio coding apparatus comprising:

   a bit-plane mapping unit (200) arranged to map an audio signal in the frequency domain having integer values into bit-plane data with respect to the frequency;
   a parameter obtaining unit (210) arranged to obtain a most significant bit and a Golomb parameter for the bit-plane;
   a binary sample selection unit (220) arranged to select a binary sample on a bit-plane to be coded in the order from the most significant bit to the least significant bit and from a lower frequency component to a higher frequency component;

a context calculation unit (230) arranged to calculate the context of the selected binary sample by using significances of already coded binary samples for each of a plurality of frequency lines existing in the vicinity of a frequency line to which the selected binary sample belongs;

a probability model selection unit (240) arranged to select a probability model of the binary sample by using the obtained Golomb parameter and the calculated contexts; and

a binary sample coding unit (250) arranged to lossless-code the binary sample by using the selected probability model.

**characterised in that** the significance of a binary sample is '1' if there is at least one '1' in already coded bit-planes in the frequency line of the binary sample and if there is no '1' in the frequency line of the binary sample, the significance of the binary sample is '0'.

8. The apparatus of claim 7, further comprising an integer/frequency transform unit (300) transforming an audio signal in the time domain into the audio spectral signal in the frequency domain having integer values.

9. The apparatus of claim 8, wherein the integer time/frequency transform unit (300) is an integer modified discrete cosine transform (MDCT) unit.

10. The apparatus of claim 7, wherein the context calculation unit comprises:

a first context calculation unit arranged to calculate a first context by obtaining the significances of already coded binary samples of bit-planes on each frequency line in a plurality of frequency lines existing in the vicinity of a frequency line to which the selected binary sample belongs and binarizing the significances; and

a second context calculation unit arranged to calculate a second context by obtaining the significances of already coded binary samples of bit-planes on each frequency line in a plurality of frequency lines existing before a frequency line to which the selected binary sample belongs, expressing a ratio on how many lines among the plurality of frequency tines have significance "1", in an integer by multiplying the ratio by a predetermined integer value, and then, calculating the second context by using the integer.

11. The apparatus of claim 7, wherein the apparatus is arranged to code some binary samples on the bit-plane with the probability of 0.5.

12. A lossless audio coding apparatus according to any of claims 7 to 91 further comprising:

a scaling unit (310) arranged to scale the audio spectral signal in the frequency domain having an integer value to be used as an input signal of a lossy coder;

a lossy coding unit (320) arranged to lossy compression code the scaled frequency signal;

an error mapping unit (330) arranged to obtain the difference of the lossy coded signal and the signal of the integer time/frequency transform unit; and

a multiplexer (350) arranged to generate a bitstream by multiplexing the lossless coded signal and the lossy coded signal;

wherein the lossless audio coding apparatus is an arithmetic lossless coding unit (340) being an apparatus according to any of claims 8 to 12.

13. A lossless audio decoding method comprising:

obtaining (1900) a Golomb parameter from a bitstream of audio data;

selecting (1910) a binary sample to be decoded in the order from a most significant bit to a least significant bit and from a lower frequency to a higher frequency;

calculating (1920) the context of a binary sample to be decoded by using the significances of already decoded binary samples of bit-planes for each of a plurality of frequency lines existing in the vicinity of a frequency line to which the binary sample to be decoded belongs;

selecting (1930) a probability model of the binary sample by using the Golomb parameter and the context;

performing arithmetic-decoding (1940) by using the selected probability model; and

repeatedly performing the operations from the selecting of a binary sample to be decoded to the arithmetic decoding until all binary samples are decoded

wherein the significance of a binary sample is '1' if there is at least one '1' in already decoded bit-planes in the frequency line of the binary sample and if there is no '1' in the already decoded bit-planes in the frequency line of the binary sample, the significance of the binary sample is '0'.

14. A lossless audio decoding method according to claim 13 wherein the difference of lossy coded audio data and an audio spectral signal in the frequency domain having an integer value is referred to as error data, the method comprising:

extracting (2000) a lossy bitstream lossy-coded in a predetermined method and an error bitstream of the error data, by demultiplexing an audio bitstream;

lossy-decoding (2010) the extracted lossy bitstream in a predetermined method;

lossless-decoding (2020) the extracted error bitstream, using a method according to any of claims 15 to 19; and

restoring (2030) a frequency spectral signal by using the decoded lossy bitstream and the extracted error bitstream; and

restoring (2040) an audio signal in the time domain by inverse integer time/frequency transforming the frequency spectral signal.

15. A lossless audio decoding apparatus comprising:

a parameter obtaining unit (1500) arranged to obtain a Golomb parameter from a bitstream of audio data;

a sample selection unit (1510) arranged to select a binary sample to be decoded in the order from a most significant bit to a least significant bit and from a lower frequency to a higher frequency;

a context calculation unit (1520) arranged to calculate the context of a binary sample to be decoded by using the significances of already decoded binary samples for each of a plurality of frequency lines existing in the vicinity of a frequency line to which the binary sample to be decoded belongs;

a probability model selection unit (1530) arranged to select a probability model by using the Golomb parameter and the context; and

an arithmetic decoding unit (1540) arranged to perform arithmetic-decoding by using the selected probability model;

wherein the significance of a binary sample is '1' if there is at least one '1' in already decoded bit-planes in the frequency line of the binary sample and if there is no '1' in the already decoded bit-planes in the frequency line of the binary sample, the significance of the binary sample is '0'.

16. The apparatus of claim 15, wherein the context calculation unit comprises:

a first context calculation unit (1600) arranged to calculate a first context by obtaining the significances of already decoded binary samples on each frequency line in a plurality of frequency lines existing in the vicinity of a frequency line to which a binary sample to be decoded belongs and binarizing the significances; and

a second context calculation unit (1620) arranged to calculate a second context by obtaining the significances of already decoded binary samples on each frequency line in a plurality of frequency lines existing before a frequency line to which a binary sample to be decoded belongs, expressing a ratio on how many lines among the plurality of frequency lines have significance, in an integer by multiplying the ratio by a predetermined integer value, and then, by using the integer to calculate the second context.

17. The apparatus of claim 15 or 16, some binary samples on the bit-plane are decoded with probability of 0.5.

18. A lossless audio decoding apparatus according to any of claims 15 to 17 wherein the difference of lossy coded audio data and an audio spectral signal in the frequency domain having an integer value is referred to as error data, the apparatus comprising:

a demultiplexing unit (1700) arranged to extract a lossy bitstream lossy-coded in a predetermined method and an error bitstream of the error data, by demultiplexing an audio bitstream;

a lossy decoding unit (1710) arranged to lossy-decode the extracted lossy bitstream in a predetermined method;

a lossless decoding unit (1720) arranged to lossless-decode the extracted error bitstream, by using a context based on the significances of already decoded binary samples of bit-planes on each line of a plurality of frequency lines existing in the vicinity of a frequency line to which a binary sample to be decoded belongs; and

an audio signal synthesis unit (1730) arranged to restore a frequency spectral signal by synthesizing the decoded lossy bitstream and error bitstream.

19. The apparatus of claim 18, wherein the lossy decoding unit is an AAC decoding unit.

20. The apparatus of claim 18 or 19, further comprising:

an inverse integer time/frequency transform unit (1740) arranged to restore an audio signal in the time domain by inverse integer time/frequency transforming the frequency spectral signal.

21. The apparatus of claim 18, 19 or 20, further comprising:

an inverse time/frequency transform unit (1750) arranged to restore an audio signal in the time domain from the audio signal in the frequency domain decoded by the lossy decoding unit.

22. A computer readable recording medium having embodied thereon a computer program comprising instructions which, when run on a computer, will cause said computer to perform the method of claim 1 or 6.

23. A computer readable recording medium having embodied thereon a computer program comprising instructions which, when run on a computer, will cause said computer to perform the method of claim 13 or 14.

**Patentansprüche**

1. Verlustfreies Audiokodierungsverfahren, das Folgendes umfasst:

Umsetzen (600) eines Audiospektralsignals in dem Frequenzbereich mit ganzzahligen Werten in ein' Bitebenensignal in Bezug auf die Frequenz;

Erlangen (610) eines höchstwertigen Bits und eines Colomb-Parameters für jede Bitebene;

Auswählen (620) eines binären Abtastwerts einer zu kodierenden Bitebene in der Reihenfolge vom höchstwertigen Bit zum niedrigstwertigen Bit und von einer Komponente mit einer niedrigeren Frequenz zu einer Komponente mit einer höheren Frequenz;

Berechnen (630) des Kontexts des ausgewählten binären Abtastwerts;

Auswählen (640) eines Wahrscheinlichkeitsmodells des binären Abtastwerts durch Verwendung des erlangten Golomb-Parameters und der berechneten Kontexte und arithmetisches verlustfreies Kodieren (650) des binären Abtastwerte durch Verwendung des ausgewählten wahrscheinlichkeitamodells;

**dadurch gekennzeichnet, dass** der Kontext des ausgewählten binären Abtastwerts unter Verwendung der Signifikanzen bereits kodierter binärer Abtastwerte für jede einer Vielzahl von Frequenzlinien, die in der Nähe einer Frequenzlinie existieren, zu der der ausgewählte binäre Abtastwert gehört, berechnet wird;

wobei die Signifikanz eines binären Abtastwerts "1" ist, wenn mindestens eine "1" in bereits kodierten Bitebenen in der Frequenzlinie des binären Abtastwerts vorliegt, und wenn keine "1" in der Frequenzlinie des binären Abtastwerts vorliegt, die Signifikanz des binären Abtastwerts "0" ist.

2. Verfahren nach Anspruch 1, wobei im Schritt des Berechnens (630) des Kontexts des ausgewählten binären Abtastwerts die Signifikanzen bereits kodierter binärer Abtastwerte von Bitebenen auf jeder Frequenzlinie in einer Vielzahl von Frequenzlinien, die in der Nähe einer Frequenzlinie existieren, zu der der ausgewählte binäre Abtastwert gehört, erlangt werden und durch Binarisieren der Signifikanzen der Kontextwert des binären Abtastwerts berechnet wird.

3. Verfahren nach einem der vorhergehenden Ansprüche, wobei beim Berechnen (630) des Kontexts des ausgewählten binären Abtastwerts die Signifikanzen bereits kodierter binärer Abtastwerte von Bitebenen auf jeder Frequenzlinie in einer Vielzahl von Frequenzlinien, die vor einer Frequenzlinie existieren, zu der der ausgewählte binäre Abtastwert gehört, erlangt werden; ein Verhältnis, wie viele binäre Abtastwerte aus der Vielzahl von binären Abtastwerten die Signifikanz "1" aufweisen, in einer ganzen Zahl ausgedrückt wird, indem das Verhältnis mit einem vorher bestimmten ganzzahligen Wert multipliziert wird; und dann der Kontextwert des binären Abtastwerts durch Verwendung der ganzen Zahl berechnet wird.

4. Verfahren nach einem der vorhergehenden Ansprüche, wobei das Berechnen des Kontexts des ausgewählten binären Abtastwerts Folgendes umfasst,:

Berechnen eines ersten Kontexts durch Verwendung der Signifikanzen bereits kodierter binärer Abtastwerte von Bitebenen auf jeder Frequenzlinie in einer ersten Vielzahl von Frequenzlinien, die in der Nähe einer Frequenzlinie existieren, zu der der zu kodierende binäre Abtastwert gehört; und

Berechnen eines zweiten Kontexts durch Verwendung der Signifikanzen bereits kodierter binärer Abtastwerte von Bitebenen auf jeder Frequenzlinie in einer zweiten Vielzahl von Frequenzlinien vor einer Frequenzlinie, zu der der zu kodierende binäre Abtastwert gehört.

5. Verfahren nach einem der vorhergehenden Ansprüche, wobei manche binäre Abtastwerte auf der Bitebene mit einer Wahrscheinlichkeit von 0,5 kodiert werden.

6. Verlustfreies Audiokodierungsverfahren nach einen der Ansprüche 1 bis 5, das Folgendes umfasst:

Skalieren (720) eines Audiospektralsignals in dem Frequenzbereich mit ganzzahligen Werten, das als ein Eingangssignal eines verlustreichen Kodierers verwendet werden soll;

verlustreiches Kompressionskodieren (730) des skalierten Frequenzsignals;

Erlangen (740) eines Fehlerumsetzungssignals entsprechend dem Unterschied zwischen den verlustreichen kodierten Daten und dem Audiospektralsignal in dem Frequenzbereich mit einem ganzzahligen Wert;

verlustreiches Kodieren (750) des Fehlerumsetzungssignals unter Verwendung eines Verfahrens nach einem der Ansprüche 1 bis 6 unter Verwendung des Fehlerumsetzungssignals als dem Audiospektralsignal und

Erzeugen eines Bitstroms durch Multiplexieren (760) des verlustfreien kodierten Signals und des verlustreichen kodierten Signals.

7. Verlustfreie Audiokodierungsvorrichtung, die Folgendes umfasst:

eine Einheit zum Umsetzen von Bitebenen (200), die darauf eingerichtet ist, ein Audiosignal in dem Frequenzbereich mit ganzzahligen Werten in Bitebenendaten in Bezug auf die Frequenz umzusetzen;

eine Einheit zum Erlangen von Parametern (210), die darauf eingerichtet ist, ein höchstwertiges Bit und einen Golomb-Parameter für die Bitebene zu erlangen;

eine Einheit zum Auswählen von binären Abtastwerten (220), die darauf eingerichtet ist, einen binären Abtastwert auf einer zu kodierenden Bitebene in der Reihenfolge vom höchstwertigen Bit zum niedrigstwertigen Bit und von einer Komponente mit einer niedrigeren Frequenz zu einer Komponente mit einer höheren Frequenz auszuwählen;

eine Einheit zum Berechnen von Kontexten (230), die darauf eingerichtet ist, den Kontext des ausgewählten binären Abtastwerts durch Verwendung von Signifikanzen bereits kodierter binärer Abtastwerte für jede einer Vielzahl von Frequenzlinien, die in der Nähe einer Frequenzlinie existieren, zu der der ausgewählte binäre Abtastwert gehört, zu berechnen;

eine Einheit zum Auswählen eines Wahrscheinlichkeitsmodells (240), die darauf eingerichtet ist, ein Wahrscheinlichkeitsmodell des binären Abtastwerts durch Verwendung des erlangten Golomb-Parameters und der berechneten Kontexte auszuwählen; und eine Einheit zum Kodieren von binären Abtastwerten (250), die darauf eingerichtet ist, den binären Abtastwert durch Verwendung des ausgewählten Wahrscheinlichkeitsmodells verlustfrei zu kodieren; **dadurch gekennzeichnet, dass** die Signifikanz eines binären Abtastwerts "1" ist, wenn mindestens eine "1" in bereits kodierten Bitebenen in der Frequenzlinie des binären Abtastwerts vorliegt, und wenn keine "1" in der Frequenzlinie des binären Abtastwerts vorliegt, die Signifikanz des binären Abtastwerts "O" ist.

8. Vorrichtung nach Anspruch 7, die weiterhin eine Einheit zum Umwandeln von ganzzahligen Zeiten/Frequenzen (300) umfasst, die ein Audiosignal in dem Zeitbereich in das Audiospektralsignal in dem Frequenzbereich mit ganzzahligen Werten umwandelt.

9. Vorrichtung nach Anspruch 8, wobei es sich bei der Einheit zum Umwandeln von ganzzahligen Zeiten/Frequenzen (300) um eine Einheit zur ganzzahligen modifizierten diskreten Cosinustransformation (MDCT-Einheit) handelt.

10. Vorrichtung nach Anspruch 7, wobei die Einheit zum Berechnen von Kontexten Folgendes umfasst:

eine erste Einheit zum Berechnen von Kontexten, die darauf eingerichtet ist, einen ersten Kontext zu berechnen durch Erlangen der Signifikanzen bereits kodierter binärer Abtastwerte von Bitebenen auf jeder Frequenzlinie in einer ersten Vielzahl von Frequenzlinien, die in der Nähe einer Frequenzlinie existieren, zu der der ausgewählte binäre Abtastwert gehört, und Binarisieren der Signifikanzen; und

eine zweite Einheit zum Berechnen von Kontexten, die: darauf eingerichtet ist, einen zweiten Kontext zu berechnen durch Erlangen der Signifikanzen bereits kodierter binärer Abtastwerte von Bitebenen auf jeder Frequenzlinie in einer zweiten Vielzahl von Frequenzlinien, die vor einer Frequenzlinie existieren, zu der der ausgewählte binäre Abtastwert gehört, Ausdrücken eines Verhältnisses, wie viele Linien aus der Vielzahl von Frequenzlinien die Signifikanz "1" aufweisen, in einer ganzen Zahl, indem das Verhältnis mit einem vorher bestimmten ganzzahligen Wert multipliziert wird; und dann Berechnen des zweiten Kontexts durch Verwendung der ganzen Zahl.

11. Vorrichtung nach Anspruch 7, wobei die Vorrichtung darauf eingerichtet ist, manche binäre Abtastwerte auf der Bitebene mit einer Wahrscheinlichkeit von 0,5 zu kodieren.

12. Verlustfreie Audiokodierungsvorrichtung nach einem der Ansprüche 7 bis 11, die weiterhin Folgendes umfasst:

eine Skalierungseinheit (310), die darauf eingerichtet ist, das Audiospektralsignal in dem Frequenzbereich mit einem ganzzahligen Wert zu skalieren, das als ein Eingangssignal eines verlustreichen Kodierers verwendet werden soll;

eine verlustreiche Kodiereinheit (320), die darauf eingerichtet ist, das skalierte Frequenzsignal verlustreich zu kompressionskodieren;

eine Fehlerumsetzungseinheit (330), die darauf eingerichtet ist, den Unterschied zwischen dem verlustreichen kodierten Signal und dem Signal der Einheit zum Umwandeln von ganzzahligen Zeiten/Frequenzen zu erlangen; und

einen Multiplexer (350), dir darauf eingerichtet ist, einen Bitstroms durch Multiplexieren des verlustfreien kodierten Signals und des verlustreichen kodierten Signals zu erzeugen;
wobei die verlustfreie Audiokodierungsvorrichtung eine arithmetische verlustfreie Kodiereinheit (340) ist, bei der es sich um eine Vorrichtung nach einem der Ansprüche 8 bis 12 handelt.

13. Verlustfreies Audiodekodierungsverfahren das Folgendes umfasst:

Erlangen (1900) eines Golomb-Parameters aus einem Bitstrom von Audiodaten;
Auswählen (1910) eines zu dekodierenden binären Abtastwerts in der Reihenfolge von einem höchstwertigen Bit zu einem niedrigstwertigen Bit und von einer niedrigeren Frequenz zu einer höheren Frequenz;
Berechnen (1920) des Kontexts eines zu dekodierenden binären Abtastwerts durch Verwendung der Signifikanzen bereits dekodierter binärer Abtastwerte von Bitebenen auf für jede einer Vielzahl von Frequenzlinien, die in der Nähe einer Frequenzlinie existieren, zu der der zu dekodierende binäre Abtastwert gehört;
Auswählen (1930) eines Wahrscheinlichkeitsmodells des binären Abtastwerts durch Verwendung des Golomb-Parameters und des Kontexts;
Durchführen eines arithmetischen Dekodierens (1940) durch Verwendung des ausgewählten Wahrscheinlichkeitsmodells und wiederholtes Durchführen der Arbeitsschritte vom Auswählen eines zu dekodierenden binären Abtastwerts zum arithmetischen Dekodieren, bis alle binären Abtastwerte dekodiert wurden;
wobei die Signifikanz eines binären Abtastwerts "1" ist, wenn mindestens eine "1" in bereits dekodierten Bitebenen in der Frequenzlinie des binären Abtastwerts vorliegt, und wenn keine "1" in den bereits dekodierten Bitebenen in der Frequenzlinie des binären Abtastwerts vorliegt, die Signifikanz des binären Abtastwerts "O" ist.

14. Verlustfreies Audiodekodierungsverfahren nach Anspruch 13, wobei der Unterschied zwischen verlustreich kodierten Audiodaten und einem Audiospektralsignal in dem Frequenzbereich mit einem ganzzahligen Wert als Fehlerdaten bezeichnet wird, wobei das Verfahren Folgendes umfasst:

Extrahieren (2000) eines verlustreichen Bitstroms, der in einem vorher bestimmten Verfahren verlustreich kodiert wurde, und eines Fehlerbitstroms der Fehlerdaten durch Demultiplexieren eines Audiobitstroms;
verlustreiches Dekodieren (2010) des extrahierten verlustreichen Bitstroms in einem vorher bestimmten Verfahren;

verlustfreies Dekodieren (2020) des extrahierten Fehlerbitstroms unter Verwendung eines Verfahrens nach einem der Ansprüche 15 bis 19 und
Wiederherstellen (2030) eines Frequenzspektralsignals durch Verwendung des dekodierten verlustreichen Bitstroms und des extrahierten Fehlerbitstroms und
Wiederherstellen (2040) eines Audiosignals in dem Zeitbereich durch Umkehrumwandlung von ganzzahligen Zeiten/Frequenzen des Frequenzspektralsignals.

15. Verlustfreie Audiodekodierungsvorrichtung, die Folgendes umfasst:

eine Einheit zum Erlangen von Parametern (1500), die darauf eingerichtet ist, einen Golomb-Parameter aus einem Bitstrom von Audiodaten zu erlangen;
eine Einheit zum Auswählen von Abtastwerten (1510), die darauf eingerichtet ist, einen zu dekodierenden binären Abtastwert in der Reihenfolge von einem höchstwertigen Bit zu einem niedrigstwertigen Bit und von einer niedrigeren Frequenz zu einer höheren Frequenz auszuwählen;
eine Einheit zum Berechnen von Kontexten (1520), die darauf eingerichtet ist, den Kontext eines zu dekodierenden binären Abtastwerts durch Verwendung der Signifikanzen bereits kodierter binärer Abtastwerte für jede einer Vielzahl von Frequenzlinien, die in der Nähe einer Frequenzlinie existieren, zu der der zu dekodierende binäre Abtastwert gehört, zu berechnen;
eine Einheit zum Auswählen eines Wahrscheinlichkeitsmodells (1530), die darauf eingerichtet ist, ein Wahrscheinlichkeitsmodell durch Verwendung des Golomb-Parameters und des Kontexts auszuwählen; und
eine arithmetische Dekodiereinheit (1540), die darauf eingerichtet ist, arithmetisches Dekodieren durch Verwendung des ausgewählten Wahrscheinlichkeitsmodells durchzuführen;
wobei die Signifikanz eines binären Abtastwerts "1" ist, wenn mindestens eine "1" in bereits dekodierten Bitebenen in der Frequenzlinie des binären Abtastwerts vorliegt, und wenn keine "1" in den bereits dekodierten Bitebenen in der Frequenzlinie des binären Abtastwerts vorliegt, die Signifikanz des binären Abtastwerts "0" ist.

16. Vorrichtung nach Anspruch 15, wobei die Einheit zum Berechnen von Kontexten Folgendes umfasst:

eine erste Einheit zum Berechnen von Kontexten (1600), die darauf eingerichtet ist, einen ersten Kontext zu berechnen durch Erlangen der Signifikanzen bereits dekodierter binärer Abtastwerte auf jeder Frequenzlinie in einer Vielzahl von Frequenzlinien, die in der Nähe einer Frequenzlinie existieren, zu der ein zu dekodierender binärer Abtastwert gehört, und Binarisieren der Signifikanzen; und

eine zweite Einheit zum Berechnen von Kontexten (1620), die darauf eingerichtet ist, einen zweiten Kontext zu berechnen durch Erlangen der Signifikanzen bereits dekodierter binärer Abtastwerte auf jeder Frequenzlinie in einer Vielzahl von Frequenzlinien, die vor einer Frequenzlinie existieren, zu der ein zu dekodierender binärer Abtastwert gehört, Ausdrücken eines Verhältnisses, wie viele Linien aus der Vielzahl von Frequenzlinien eine Signifikanz aufweisen, in einer ganzen Zahl, indem das Verhältnis mit einem vorher bestimmten ganzzahligen Wert multipliziert wird, und dann durch Verwendung der ganzen Zahl, um den zweiten Kontext zu berechnen.

17. Vorrichtung nach Anspruch 15 oder 16, wobei manche binäre Abtastwerte auf der Bitebene mit einer Wahrscheinlichkeit von 0,5 kodiert werden.

18. Verlustfreie Audiodekodierungsvorrichtung nach einem der Ansprüche 15 bis 17, wobei der Unterschied zwischen verlustreich kodierten Audiodaten und einem Audiospektralsignal in dem Frequenzbereich mit einem ganzzahligen Wert als Fehlerdaten bezeichnet wird, wobei die Vorrichtung Folgendes umfasst:

eine Demultiplexiereinheit (1700), die darauf eingerichtet ist, einen verlustreichen Bitstrom, der in einem vorher bestimmten Verfahren verlustreich kodiert wurde, und einen Fehlerbitstrom der Fehlerdaten durch Demultiplexieren eines Audiobitstroms zu extrahieren; eine verlustreiche Dekodiereinheit (1710), die darauf eingerichtet ist, den extrahierten verlustreichen Bitstrom in einem vorher bestimmten Verfahren verlustreich zu, dekodieren; eine verlustfreie Dekodiereinheit (1720), die darauf eingerichtet ist, den extrahierten Fehlerbitstrom durch Verwendung eines Kontextes verlustfrei zu dekodieren, der auf den Signifikanzen bereits dekodierter binärer Abtastwerte von Bitebenen auf jeder Linie einer Vielzahl von Frequenzlinien basiert, die in der Nähe einer Frequenzlinie existieren, zu der ein zu dekodierender binäre Abtastwert gehört; und eine Audiosignalsyntheseeinheit (1730), die darauf eingerichtet ist, ein Frequenzspektralsignal durch Synthetisieren des dekodierten verlustreichen Bitstroms und des Fehlerbitstroms wiederherzustellen.

19. Vorrichtung nach Anspruch 18, wobei es sich bei der verlustreichen Dekodiereinheit um eine AAC-Dekodiereinheit handelt.

20. Vorrichtung nach Anspruch 18 oder 19, die weiterhin Folgendes umfasst:

eine Einheit zum Umkehrumwandeln von ganzzahligen Zeiten/Frequenzen (1740), die darauf eingerichtet ist, ein Audiosignal in dem Zeitbereich durch Umkehrumwandeln von ganzzahligen Zeiten/Frequenzen des Frequenzspektralsignals wiederherzustellen.

21. Vorrichtung nach Anspruch 18, 19 oder 20, die weiterhin Folgendes umfasst:

eine Einheit zum Umkehrumwandeln von Zeiten/Frequenzen (1750), die darauf eingerichtet ist, ein Audiosignal in dem Zeitbereich aus dem Audiosignal in dem Frequenzbereich wiederherzustellen, das von der verlustreichen Dekodiereinheit dekodiert wurde.

22. Computerlesbares Aufzeichnungsmedium, das darauf enthalten ein Computerprogramm aufweist, das Befehle umfasst, die, wenn es auf einem Computer ausgeführt wird, bewirken wird, dass der Computer das Verfahren nach Anspruch 1 oder 6 durchführt.

23. Computerlesbares Aufzeichnungsmedium, das darauf enthalten ein Computerprogramm aufweist, das Befehle umfasst, die, wenn es auf einem Computer ausgeführt wird, bewirken wird, dass der Computer das Verfahren nach Anspruch 13 oder 14 durchführt.

**Revendications**

1. Procédé de codage audio sans perte comprenant :

le mappage (600) d'un signal spectral audio dans le domaine de fréquence ayant des valeurs entières dans un signal de plan de bits par rapport à la fréquence ; l'obtention (610) d'un bit le plus significatif et d'un paramètre de Golomb pour chaque plan de bits ; la sélection (620) d'un échantillon binaire d'un plan de bits à coder dans l'ordre du bit le plus significatif au bit le moins significatif et d'une composante de fréquence inférieure à une composante de fréquence supérieure ; le calcul (630) du contexte de l'échantillon binaire sélectionné ; la sélection (640) d'un modèle de probabilité de l'échantillon binaire en utilisant le paramètre de Golomb obtenu et les contextes calculés ; et

le codage arithmétique sans perte (650) de l'échantillon binaire en utilisant le modèle de probabilité sélectionné ;

**caractérisé en ce que** le contexte de l'échantillons binaire sélectionné est calculé en utilisant les significations des échantillons binaires déjà codés pour chacune d'une pluralité de lignes de fréquence existant à proximité d'une ligne de fréquence à laquelle appartient l'échantillon binaire sélectionné ;

dans lequel la signification d'un échantillon binaire est '1' s'il y a au moins un '1' dans les plans de bits déjà codés dans la ligne de fréquence de l'échantillon binaire, et s'il n'y a pas de '1' dans la ligne de fréquence de l'échantillon binaire, la signification de l'échantillon binaire est '0'.

2. Procédé selon la revendication 1, dans lequel, dans l'étape de calcul (630) du contexte de l'échantillon binaire sélectionné, les significations des échantillon binaires déjà codés des plans de bits sur chaque ligne de fréquence dans une pluralité de lignes de fréquence existant à proximité d'une ligne de fréquence à laquelle appartient l'échantillon binaire sélectionné sont obtenues et, par binarisation des significations, la valeur de contexte de l'échantillon binaire est calculée.

3. Procédé selon l'une quelconque des revendications précédentes, dans lequel, dans le calcul (630) du contexte de l'échantillon binaire sélectionné, les significations des échantillons binaires déjà codés des plans de bits sur chaque ligne de fréquence d'une pluralité de lignes de fréquence existant avant une ligne de fréquence à laquelle appartient l'échantillon binaire sélectionné sont obtenues ; un rapport du nombre d'échantillons binaires parmi la pluralité d'échantillons binaires qui ont la signification "1" est exprimé dans un nombre entier, en multipliant le rapport par une valeur entière prédéterminée ; puis la valeur de contexte de l'échantillon binaire est calculée au moyen du nombre entier.

4. Procédé selon l'une quelconque des revendications précédentes, dans lequel le calcul du contexte de l'échantillon binaire sélectionné comprend :

le calcul d'un premier contexte en utilisant les significations des échantillons binaires déjà codés du plan de bits sur chaque ligne de fréquence d'une première pluralité de lignes de fréquence existant à proximité d'une ligne de fréquence à laquelle appartient un échantillon binaire à coder ; et

le calcul d'un deuxième contexte en utilisant les significations d'échantillons binaires déjà codés de plans de bits sur chaque ligne de fréquence dans une deuxième pluralité de lignes de fréquence avant une ligne de fréquence à laquelle appartient un échantillon binaire à coder.

5. Procédé selon l'une quelconque des revendications précédentes, dans lequel certains échantillons binaires sur le plan de bits sont codés avec une probabilité de 0,5.

6. Codage audio sans perte selon l'une quelconque des revendications 1 à 5, comprenant :

la mise à l'échelle (720) d'un signal spectral audio dans le domaine de fréquence ayant des valeurs entières à utiliser comme signal d'entrée d'un codeur à perte ;

le codage de compression avec perte (730) du signal de fréquence mis à l'écuelle

l'obtention (740) d'un signal d'erreur mappé correspondant à la différence des données codées avec perte et du signal spectral audio dans le domaine de fréquence ayant une valeur entière ;

le codage sans perte (750) du signal d'erreur mappé par un procédé selon l'une quelconque des revendications 1 à 6 en utilisant le signal d'erreur mappé comme signal spectral audio ; et

la génération d'un train de bits en multiplexant (760) le signal codé sans perte et le signal codé avec perte.

7. Appareil de codage audio sans perte comprenant :

une unité de mappage de plan de bits (200) agencée pour mapper un signal audio dans le domaine de fréquence ayant des valeurs entières en données de plan de bits par rapport à la fréquence ;

une unité d'obtention de paramètres (210) agencée pour obtenir un bit le plus significatif et un paramètre de Golomb pour le plan de bits ;

une unité de sélection d'échantillon binaire (220) agencée pour sélectionner un échantillon binaire sur un plan de bits à coder dans l'ordre du bit le plus significatif au bit le moins significatif et d'une composante de fréquence inférieure à une composante de fréquence supérieure ;

une unité de calcul de contexte (230) agencée pour calculer le contexte de l'échantillon binaire sélectionné en utilisant les significations des échantillons binaires déjà codés pour chacune d'une pluralité de lignes de fréquence existant à proximité d'une ligne de fréquence à laquelle appartient l'échantillon binaire sélectionné ;

une unité de sélection de modèle de probabilité (240) agencée pour sélectionner un modèle de probabilité de l'échantillon binaire en utilisant le paramètre de Golomb obtenu et les contextes calculés ; et

une unité de codage d'échantillon binaire (250) agencée pour coder sans perte l'échantillon binaire en utilisant le modèle de probabilité sélectionné;

**caractérisé en ce que** la signification d'un échantillon binaire est '1' s'il y a au moins un '1' dans les plans de bits déjà codés dans la ligne de fréquence de l'échantillon binaire, et s'il n'y a pas de '1' dans la ligne de fréquence de l'échantillon binaire, la signification de l'échantillon binaire est '0'.

8. Appareil selon la revendication 7, comprenant en outre une unité de transformation nombre entier/fréquence (300) transformant un signal audio dans le domaine de temps en signal spectral audio dans le domaine de fréquence ayant des valeurs entières.

9. Appareil selon la revendication 8, dans lequel l'unité de transformation temps entier/fréquence (300) est une unité de transformation en cosinus discrets modifiée (MDCT) entiers.

10. Appareil selon la revendication 7, dans lequel l'unité de calcul de contexte comprend :

une première unité de calcul de contexte agencée pour calculer un premier contexte en obtenant les significations d'échantillons binaires déjà codés de plans de bits sur chaque ligne de fréquence d'une pluralité de lignes de fréquence existant à proximité d'une ligne de fréquence à laquelle appartient l'échantillon binaire sélectionné, et la binarisation des significations ; et
une deuxième unité de calcul de contexte agencée pour calculer un deuxième contexte en obtenant les significations d'échantillons binaires déjà codés de plans de bits sur chaque ligne de fréquence d'une pluralité de lignes de fréquence existant avant une ligne de fréquence à laquelle appartient l'échantillon binaire sélectionné, en exprimant un rapport du nombre de lignes parmi la pluralité de lignes de fréquence qui ont la signification "1" en un nombre entier, en multipliant le rapport par une valeur entière prédéterminée, puis en calculant le deuxième contexte en utilisant le nombre entier.

11. Appareil selon la revendication 7, dans lequel l'appareil est agencé pour coder certains échantillons binaires sur le plan de bits avec la probabilité de 0,5.

12. Appareil de codage audio sans perte selon l'une quelconque des revendications 7 à 11, comprenant en outre :

une unité de mise à l'échelle (310) agencée pour mettre à l'échelle le signal spectral audio dans le domaine de fréquence ayant une valeur entière à utiliser comme signal d'entrée d'un codeur avec perte ;
une unité de codage avec perte (320) agencée pour coder par compression avec perte le signal de fréquence mis à l'échelle ;
une unité de mappage d'erreur (330) agencée pour obtenir la différence du signal codé avec perte et du signal de l'unité de transformation temps entier/ fréquence ; et
un multiplexeur (350) agencé pour générer un train de bits en multiplexant le signal codé sans perte et le signal codé avec perte ;
l'appareil de codage audio sans perte étant une unité de codage sans perte arithmétique (340) qui est un appareil selon l'une quelconque des revendications 8 à 12.

13. Procédé de décodage audio sans perte comprenant :

l'obtention (1900) d'un paramètre de Golomb à partir d'un train de bits de données audio ;
la sélection (1910) d'un échantillon binaire à décoder dans l'ordre d'un bit le plus significatif à un bit le moins significatif, et d'une fréquence inférieure à une fréquence supérieure ;
le calcul (1920) du contexte d'un échantillon binaire à décoder en utilisant les significations d'échantillons binaires déjà décodés de plans de bits pour chacune d'une pluralité de lignes de fréquence existant à proximité d'une ligne de fréquence à laquelle appartient l'échantillon binaire à décoder ;
la sélection (1930) d'un modèle de probabilité de l'échantillon binaire en utilisant le paramètre de Golomb et le contexte ;
l'exécution d'un décodage arithmétique (1940) en utilisant le modèle de probabilité sélectionné ; et
l'exécution répétée des opérations de la sélection d'un échantillon binaire à décoder jusqu'au décodage arithmétique, jusqu'à ce que tous les échantillons binaires soient décodés
dans lequel la signification d'un échantillon binaire est '1' s'il y a au moins un '1' dans les plans de bits déjà décodés dans la ligne de fréquence de l'échantillon binaire et, s'il n'y a pas de '1' dans les plans de bits déjà décodés dans la ligne de fréquence de l'échantillon binaire, la signification de l'échantillon binaire est '0'.

14. Procédé de décodage audio sans perte selon la revendication 13, dans lequel la différence des données audio codées avec perte et d'un signal spectral audio dans le domaine de fréquence ayant une valeur entière est désignée données d'erreur, le procédé comprenant :

l'extraction (2000) d'un train de bits avec perte codé avec perte dans un procédé prédéterminé et d'un train de bits d'erreur des données d'erreur en démultiplexant un train de bits audio ;
le décodage avec perte (2010) du train de bits extrait avec perte dans un procédé prédéterminé ;
le décodage sans perte (2020) du train de bits d'erreur extrait, en utilisant un procédé selon l'une quelconque des revendications 15 à 19 ; et
la restauration (2030) d'un signal spectral de fréquence en utilisant le train de bits décodé avec perte et le train de bits d'erreur extrait ; et
la restauration (2040) d'un signal audio dans le domaine de temps par transformation inverse temps entier/fréquence du signal spectral de fréquence.

15. Appareil de décodage audio sans perte comprenant :

une unité d'obtention de paramètre (1500) agencée pour obtenir un paramètre de Golomb à partir d'un train de bits de données audio ;
une unité de sélection d'échantillon (1510) agencée pour sélectionner un échantillon binaire à décoder dans l'ordre d'un bit le plus significatif à un bit le moins significatif et d'une fréquence inférieure à une fréquence supérieure ;
une unité de calcul de contexte (1520) agencée pour calculer le contexte d'un échantillon binaire à décoder en utilisant les significations d'échantillons binaires déjà décodés pour chacune d'une pluralité de lignes de fréquence existant à proximité d'une ligne de fréquence à laquelle appartient l'échantillon binaire à décoder ;
une unité de sélection de modèle de probabilité (1530) agencée pour sélectionner un modèle de probabilité en utilisant le paramètre de Golomb et le contexte ; et
une unité de décodage arithmétique (1540) agencée pour exécuter un décodage arithmétique en utilisant le modèle de probabilité sélectionné ;
dans lequel la signification d'un échantillon binaire est '1' s'il y a au moins un '1' dans les plans de bits déjà décodés dans la ligne de fréquence de l'échantillon binaire et, s'il n'y a pas de '1' dans les plans de bits déjà décodés dans la ligne de fréquence de l'échantillon binaire, la signification de l'échantillon binaire est 'O'.

16. Appareil selon la revendication 15, dans lequel l'unité de calcul de contexte comprend :

une première unité de calcul de contexte (1600) agencée pour calculer un premier contexte en obtenant les significations d'échantillons binaires déjà décodés sur chaque ligne de fréquence d'une pluralité de lignes de fréquence existant à proximité d'une ligne de fréquence à laquelle appartient un échantillon binaire à décoder et en binarisant les significations ; et
une deuxième unité de calcul de contexte (1620) agencée pour calculer un deuxième contexte en obtenant les significations d'échantillons binaires déjà décodés sur chaque ligne de fréquence d'une pluralité de lignes de fréquence existant avant une ligne de fréquence à laquelle appartient un échantillon binaire à décoder, en exprimant un rapport du nombre de lignes de fréquence parmi la pluralité de lignes de fréquence qui ont une signification, en un nombre entier, en multipliant le rapport par une valeur entière prédéterminée, puis en utilisant le nombre entier pour calculer le deuxième contexte.

17. Appareil selon la revendication 15 ou 16, certains échantillons binaires sur le plan de bits étant décodés avec une probabilité de 0,5.

18. Appareil de décodage audio sans perte selon l'une quelconque des revendications 15 à 17, dans lequel la différence des données audio codées avec perte et d'un signal spectral audio dans le domaine de fréquence ayant une valeur entière est désignée données d'erreur, l'appareil comprenant :

une unité de démultiplexion (1700) agencée pour extraire un train de bits avec perte codés avec perte dans un procédé prédéterminé et un train de bits d'erreur des données d'erreur, en démultiplexant un train de bits audio ;
une unité de décodage avec perte (1710) agencée pour décoder avec perte le train de bits avec perte extrait dans un procédé prédéterminé ;
une unité de décodage sans perte (1720) agencée pour décoder sans perte le train de bits d'erreur extrait, en utilisant un contexte basé sur les significations d'échantillons binaires déjà décodés de plans de bits sur chaque ligne d'une pluralité de lignes de fréquence existant à proximité d'une ligne de fréquence à laquelle appartient un échantillon binaire à décoder ; et
une unité de synthèse de signal audio (1730) agencée pour restaurer un signal spectral de fréquence en synthétisant le train de bits avec perte décodé et un train de bits d'erreur.

19. Appareil selon la revendication 18, dans lequel l'unité de décodage avec perte est une unité de décodage AAC.

20. Appareil selon la revendication 18 ou 19, comprenant en outre :

une unité de transformation inverse temps entier/fréquence (1740) agencée pour restaurer un signal audio dans le domaine de temps par transformation inverse temps entier/fréquence du signal spectral de fréquence.

**21.** Appareil selon la revendication 18, 19 ou 20, comprenant en outre :

une unité de transformation inverse temps/fréquence (1750) agencée pour restaurer un signal audio en domaine de temps à partir du signal audio dans le domaine de fréquence décodé par l'unité de décodage avec perte.

**22.** Support d'enregistrement lisible par ordinateur sur lequel est réalisé un programme d'ordinateur comprenant des instructions qui, lorsqu'elles sont exécutées sur un ordinateur, font exécuter par ledit ordinateur le procédé de la revendication 1 ou 6.

**23.** Support d'enregistrement lisible par ordinateur sur lequel est réalisé un programme d'ordinateur comprenant des instructions qui, lorsqu'elles sont exécutées sur un ordinateur, font exécuter par ledit ordinateur le procédé de la revendication 13 ou 14.

FIG. 1

100

120

PCM —→ | INTEGER TIME/FREQUENCY TRANSFORM UNIT | → | LOSSLESS-CODING UNIT | — BITSTREAM

FIG. 2

120

200

210

220

230

→ | BIT-PLANE MAPPING UNIT | → | PARAMETER OBTAINING UNIT | → | BINARY SAMPLE SELECTION UNIT | → | CONTEXT CALCULATION UNIT |

240

250

| PROBABILITY MODEL SELECTION UNIT | → | BINARY SAMPLE CODING UNIT | →

FIG. 3

EP 1 575 032 B1

FIG. 4

340

| 400 | 410 | 420 | 430 | 440 | 450 |

BIT-PLANE MAPPING UNIT → PARAMETER OBTAINING UNIT → BINARY SAMPLE SELECTION UNIT → CONTEXT CALCULATION UNIT → PROBABILITY MODEL SELECTION UNIT → BINARY SAMPLE CODING UNIT

FIG. 5

```
        ┌─────────────┐
        │    START    │
        └──────┬──────┘
               │
    ┌──────────▼──────────────┐
    │ TRANSFORM TIME DOMAIN SIGNAL │──500
    │ INTO FREQUENCY DOMAIN SIGNAL │
    │    HAVING INTEGER VALUE      │
    └──────────┬──────────────┘
               │
    ┌──────────▼──────────┐
    │ MAP INTO BIT-PLANE SIGNAL │──520
    │ WITH RESPECT TO FREQUENCY │
    └──────────┬──────────┘
               │
    ┌──────────▼──────────────┐
    │ LOSSLESS-CODING USING CONTEXT │──540
    └──────────┬──────────┘
               │
        ┌──────▼──────┐
        │     END     │
        └─────────────┘
```

FIG. 6

540

```
    ┌──────────────────────────┐
    │   MAP INTO BIT-PLANE DATA WITH   │──600
    │     RESPECT TO FREQUENCY         │
    └──────────────┬──────────────┘
                   │
    ┌──────────────▼──────────────┐
    │    OBTAIN GOLOMB PARAMETER      │──610
    └──────────────┬──────────────┘
                   │
    ┌──────────────▼──────────────┐
    │  SELECT BINARY SAMPLE ON BIT-PLANE │──620
    └──────────────┬──────────────┘
                   │
    ┌──────────────▼──────────────┐
    │  CALCULATE CONTEXT OF BINARY SAMPLE │──630
    └──────────────┬──────────────┘
                   │
    ┌──────────────▼──────────────┐
    │ SELECT PROBABILITY MODEL USING CONTEXT │──640
    └──────────────┬──────────────┘
                   │
    ┌──────────────▼──────────────┐
    │   LOSSLESS-CODING OF BINARY SAMPLE  │──650
    │      USING PROBABILITY MODEL        │
    └──────────────┬──────────────┘
                   │
                   ▼
```

FIG. 7

```
         ┌─────────────┐
         │    START    │
         └──────┬──────┘
                │
  ┌─────────────────────────────┐
  │ TRANSFORM TIME DOMAIN SIGNAL │──710
  │ INTO FREQUENCY DOMAIN SIGNAL │
  │     HAVING INTEGER VALUE     │
  └──────────────┬──────────────┘
                 │
  ┌─────────────────────────────┐
  │ SCALE FREQUENCY DOMAIN SIGNAL│──720
  │ TO BE USED AS LOSSY CODER    │
  │        INPUT SIGNAL          │
  └──────────────┬──────────────┘
                 │
  ┌─────────────────────────────┐
  │  LOSSY COMPRESSION CODING    │──730
  └──────────────┬──────────────┘
                 │
  ┌─────────────────────────────┐
  │  CALCULATE DIFFERENCE OF     │──740
  │  LOSSY-CODING DATA AND       │
  │  FREQUENCY DOMAIN AUDIO      │
  │  SPECTRAL SIGNAL             │
  └──────────────┬──────────────┘
                 │
  ┌─────────────────────────────┐
  │  LOSSLESS-CODING OF ERROR    │──750
  │  MAPPED SIGNAL USING CONTEXT │
  └──────────────┬──────────────┘
                 │
  ┌─────────────────────────────┐
  │  MULTIPLEX LOSSY-CODED SIGNAL│──760
  │  AND LOSSLESS-CODED SIGNAL   │
  └──────────────┬──────────────┘
                 │
         ┌──────────────┐
         │     END      │
         └──────────────┘
```

FIG. 8

FIG. 9

## FIG. 10

## FIG. 11

FIG. 12

BIT-PLANE

USING CONTEXT-BASED
ARITHMETIC CODING

FREQUENCY

FIG. 13

BIT-PLANE

USING CONTEXT-BASED
ARITHMETIC CODING

USING
BIT-PACKING

FREQUENCY

# FIG. 14

```
- Pseudo Code for Context Based Arithmetic Coding
/* BPGC/CBAC normal decoding */
i=0;
while ((i<LAZY_BP) && (there exists max_bp[g][sfb] - i >= 0)){
    for (g=0;g<num_windows_group;g++){
        for (sfb = 0;sfb<total_sfb;sfb++){
            cur_bp[g][sfb] = max_bp[g][sfb] - i;
            if ((cur_bp[g][sfb]>=0) && (lazy_bp[g][sfb] > 0)){
                width = swb_offset[g][sfb+1]   swb_offset[g][sfb];
                for (win=0;win<window_group_len[g];win++){
                    for (bin=0;bin<width;bin++){
                        if (!is_lle_ics_eof ()){
                            freq  = CalculateFreq();
                            res[g][win][sfb][bin] += decode(freq ) << cur_bp[g][sfb];
                            /* decode bit-plane cur_bp*/
                            if ((!is_sig[g][win][sfb][bin]) && (res[g][win][sfb][bin] )) {
                            /* decode sign bit of res if necessary */
                            res[g][win][sfb][bin] *= (decode(freq_sign))? 1:-1;
                            is_sig[g][win][sfb][bin] = 1;
                            }
                        }
                    }
                }
            }
        }
        i++;  /* progress to next bit-plane */
    }
}
}
```

EP 1 575 032 B1

## FIG. 15

BITSTREAM → | PARAMETER OBTAINING UNIT (1500) | → | SAMPLE SELECTION UNIT (1510) | → | CONTEXT CALCULATION UNIT (1520) | → | PROBABILITY MODEL SELECTION UNIT (1530) | → | ARITHMETIC DECODING UNIT (1540) | →

## FIG. 16

1520

| FIRST CONTEXT CALCULATION UNIT (1600) | → | SECOND CONTEXT CALCULATION UNIT (1620) | →

EP 1 575 032 B1

## FIG. 17

**FIG. 18**

1800 PARAMETER OBTAINING UNIT → 1810 SAMPLE SELECTION UNIT → 1820 CONTEXT CALCULATION UNIT → 1830 PROBABILITY MODEL SELECTION UNIT → 1840 ARITHMETIC DECODING UNIT

1720

FIG. 19

```
              ┌─────────────┐
              │    START    │
              └──────┬──────┘
                     │
         ┌───────────────────────┐
         │ OBTAIN GOLOMB PARAMETER│─── 1900
         └───────────┬───────────┘
                     │
         ┌───────────────────────┐
         │  SELECT BINARY SAMPLE  │─── 1910
         └───────────┬───────────┘
                     │
         ┌───────────────────────┐
         │  CONTEXT CALCULATION   │─── 1920
         └───────────┬───────────┘
                     │
         ┌───────────────────────┐
         │ SELECT PROBABILITY MODEL│─── 1930
         └───────────┬───────────┘
                     │
         ┌───────────────────────┐
         │   ARITHMETIC DECODING  │─── 1940
         └───────────┬───────────┘
                     │        1950
                  ◇─────────◇
                 ╱ ARE ALL    ╲   NO
                ◇   SAMPLES     ◇─────
                 ╲  DECODED?   ╱
                  ◇─────────◇
                     │ YES
              ┌─────────────┐
              │     END     │
              └─────────────┘
```

FIG. 20

```
         ┌──────────┐
         │  START   │
         └────┬─────┘
              │
  ┌───────────▼────────────┐
  │  EXTRACT LOSSY BITSTREAM │─── 2000
  │  AND ERROR BITSTREAM     │
  └───────────┬────────────┘
              │
  ┌───────────▼────────────┐
  │ DECODE LOSSY BITSTREAM   │─── 2010
  └───────────┬────────────┘
              │
  ┌───────────▼────────────┐
  │ DECODE ERROR BITSTREAM   │─── 2020
  └───────────┬────────────┘
              │
  ┌───────────▼─────────────────┐
  │ SYNTHESIZE DECODED LOSSY     │─── 2030
  │ BITSTREAM AND DECODED        │
  │ ERROR BITSTREAM              │
  └───────────┬─────────────────┘
              │
  ┌───────────▼─────────────────┐
  │ INVERSE TIME/FREQUENCY       │─── 2040
  │ TRANSFORM                    │
  └───────────┬─────────────────┘
              │
         ┌────▼─────┐
         │   END    │
         └──────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03077565 A

**Non-patent literature cited in the description**

- **Eunmi Oh et al.** *Improvement of coding efficiency in MPEG-4 audio scalable lossless coding,* 1-11

- **Yu et al.** A fine granular scalable perceptually lossy and lossless audio codec. *IEEE International conference on multimedia and expo,* July 2003, vol. 1, 1-65